# EUROPÄISCHE PATENTANMELDUNG

(11) **EP 1 806 426 A1**
(43) Veröffentlichungstag der Anmeldung: **11.07.2007**
(21) Anmeldenummer: 06000339.9
(22) Anmeldetag: 09.01.2006
(51) Int. Cl.: C23C 16/04, C23C 16/12, F01D 5/28, F01D 25/28

(54) **Halterung zum Halten eines metallischen Turbinenbauteils**

(71) Anmelder: SIEMENS AKTIENGESELLSCHAFT, 80333 München (DE)
(72) Erfinder: Beck, Thomas, 16341 Panketal (DE); Berndt, Thomas, 12524 Berlin (DE); Reich, Gerhard, 10717 Berlin (DE); Reymann, Helge, 14167 Berlin (DE)

(57) **Zusammenfassung**

Es wird eine Halterung (1) zum Halten eines metallischen Bauteils (3), welches wenigstens einen über eine Öffnung (6) in einer Außenfläche (8) des Bauteils (3) zugänglichen internen Kanal (4) aufweist, zur Verfügung gestellt. Die Halterung ist ausgestattet mit
- einem Lagerelement (5), welches eine Lagerfläche (11) umfasst, die derart ausgestaltet ist, dass sie ein Aufsetzen des Bauteils (3) auf das Lagerelement (5) zulässt und dabei wenigstens einem Teil der die Öffnung (6) aufweisenden Außenfläche (8) des Bauteils (1) als Auflage dient, und
- einem durch das Lagerelement (5) hindurchführenden Strömungskanal (7) mit wenigstens einer in der Lagerfläche (11) angeordneten Austrittsöffnung (15). Die Austrittsöffnung (15) ist derart in der Lagerfläche (11) angeordnet ist, dass sie bei aufgesetztem Bauteil (3) der Öffnung des internen Kanals (4) gegenüber liegt. Außerdem ist die Austrittsöffnung (15) in Form und Strömungsquerschnitt an die Öffnung (6) des internen Kanals (4) angepasst.

## Beschreibung

Die vorliegenden Erfindung betrifft eine Halterung zum Halten eines metallischen Bauteils, insbesondere eines Turbinenbauteils, welches wenigstens einen über eine Öffnung in der Außenfläche des Bauteils zugänglichen internen Kanal aufweist, bei einem Beschichtungsprozess zum Innenbeschichten des internen Kanals.

Thermisch hoch belastete Bauteile, beispielsweise Turbinenschaufeln oder Elemente von Brennkammerauskleidungen, werden zum Schutz vor zu hohen Temperaturen mit wärmedämmenden Schutzschichten versehen. Zusätzlich können solche Bauteile Kühlkanäle aufweisen, durch die während der Dauer der thermischen Belastung ein Kühlfluid geleitet wird, um die auf das Bauteil übertragene Wärme rasch abführen zu können. Um derartige Kühlkanäle vor Oxidation zu schützen bzw. die Oxidation zu verlangsamen, ist man bestrebt, die Wände der Kanäle mit einer Schutzschicht zu versehen. Als Schutzschicht kommt insbesondere eine Aluminiumschicht in Frage, die unter oxidierenden Bedingungen eine Aluminiumoxidoberfläche ausbildet, welche einer weiteren Oxidierung entgegenwirkt.

Ein Verfahren zum Alitieren von Innenbohrungen von Turbinenschaufeln, also zum Bilden einer Aluminiumbeschichtung auf den Wänden der Innenbohrungen, ist in DE 28 05 370 A1 offenbart. In dem dort beschriebenen Verfahren zur Herstellung einer Alitierschicht erfolgt eine Abscheidung des Aluminiums (A1) aus der Gasphase über Subchloridverbindungen, also Verbindungen der Form Al(Cl)ₓ mit x=1,2. Zum Durchführen des Verfahrens wird die Turbinenschaufel in einer speziellen Halterung angeordnet, die es ermöglicht, einen Subchloridgasstrom durch die Kühlkanäle zu leiten. In den Kühlkanälen disproportioniert das Subchlorid unter Bildung von Aluminium und Aluminiumchlorid (AlCl₃), wobei das abgeschiedene Aluminium die Aluminiumschicht bildet.

Aufgabe der vorliegenden Erfindung ist es, eine vorteilhafte Halterung zum Halten eines Bauteils während eines Alitierungsprozesses, in dem die Aluminiumabscheidung aus der Gasphase erfolgt, zur Verfügung zu stellen.

Diese Aufgabe wird durch eine Halterung zum Halten eines metallischen Bauteils, welches wenigstens einen über eine Öffnung in der Außenfläche des Bauteils zugänglichen internen Kanal aufweist, nach Anspruch 1 gelöst. Die abhängigen Ansprüche enthalten vorteilhafte Ausgestaltungen der Erfindung.

Eine erfindungsgemäße Halterung zum Halten eines metallischen Bauteils, welches wenigstens einen über eine Öffnung in der Außenfläche des Bauteils zugänglichen internen Kanal aufweist, umfasst:

Ein Lagerelement, welches eine Lagerfläche umfasst, die derart ausgestaltet ist, dass sie ein Aufsetzen des Bauteils auf das Lagerelement zulässt und dabei wenigstens einem Teil der die Öffnung aufweisenden Außenfläche des Bauteils als Auflage dient. Durch das Lagerelement führt ein Strömungskanal mit einer in der Lagerfläche angeordneten Ausgangsöffnung, wobei die Ausgangsöffnung derart an das zu beschichtende Bauteil angepasst in der Lagerfläche angeordnet ist, dass sie bei aufgesetztem Bauteil der Öffnung des internen Kanals in der Außenfläche des Bauteils gegenüberliegt. Zudem ist die Ausgangsöffnung in Form und Strömungsquerschnitt an die Form und den Strömungsquerschnitt der Öffnung des internen Kanals angepasst.

Die an die Öffnung des Kanals im Bauteil angepasste Austrittsöffnung des Strömungskanals ermöglicht ein gezieltes Zuführen der Gasphase, aus der die Aluminiumabscheidung stattfindet, in den Kanal des Bauteils. Im Stand der Technik weisen die Halterungen dagegen keine an das Bauteil angepassten Austrittsöffnungen für die Gasphase auf. Dies führt zu nachteiligen Strömungsverhältnissen am Übergang zwischen der Halterung und der Öffnung des Kanals des Bauteils, die unter anderem zu einer ungleichmäßigen Ablagerung führen können. Durch das gezielte Zuführen der Gasphase lässt sich zudem der für die gewünschte Alitierung notwendige Gasfluss sichern, da die Leckrate verringert werden kann.

In einer Vorteilhaften Weiterbildung der Erfindung ist der Rand der Austrittsöffnung des Strömungskanals von einer Dichtung umgeben, um die Leckrate weiter zu verringern.

Insbesondere kann der Strömungskanal mehrere an unterschiedlichen Orten der Lagerfläche angeordnete verschließbare Austrittsöffnungen aufweisen. Mit dieser Ausgestaltung ist es möglich, die Größe und Verteilung der Austrittsöffnungen in der Lagerfläche so vorzunehmen, dass die Halterung für mehrere verschiedene Bauteile, also für Bauteile mit verschieden angeordneten Öffnungen der inneren Kanäle, durch Öffnen und Verschließen der entsprechenden Austrittsöffnungen in der Lagerfläche verwendet werden kann. Es muss lediglich die geeignete Öffnung geöffnet und die übrigen Öffnungen verschlossen werden. Wenn das Bauteil mehrere interne Kanäle und/oder mehrere Öffnungen in der Außenfläche aufweist, können auch gleichzeitig mehrere Öffnungen in der Lagerfläche geöffnet werden.

Die Lagerfläche der Halterung kann in einer weiteren Ausgestaltung an die Form der Außenfläche des zu haltenden Bauteils angepasst sein. Auf diese Weise lässt sich eine gute, großflächige Auflage erzielen und die Austrittsöffnungen in der Lagerfläche lassen sich optimal an die Öffnungen in der Außenfläche der Bauteile heranführen, sodass eine sehr geringe Leckage und eine besonders störungsarme Strömung am Übergang möglich sind.

In einer besonderen Ausgestaltung kann die Halterung mit wenigstens einem über die Lagerfläche des Lagerelementes vorstehenden Stutzen ausgestattet sein. Der Strömungskanal führt dann auch durch den Stutzen, wobei am von der Lagerfläche entfernten Ende des Stutzens die Austrittsöffnung angeordnet ist. Der Stutzen ist derart in der Lagerfläche angeordnet oder anzuordnen, dass er bei aufgesetztem Bauteil an die Öffnung in der Außenfläche des Bauteils angrenzt oder in diese hineinragt. Diese Ausgestaltung ist insbesondere dann nützlich, wenn beispielsweise nur der Rand der Lagerfläche als Auflage für das Bauteil dient und in den anderen Bereichen die Außenfläche des Bauteils von der Lagerfläche entfernt ist. Mit Hilfe des Stutzens kann so die Austrittsöffnung des Strömungskanals sehr nah an die Öffnung des internen Kanals des Bauteils in der Außenfläche herangeführt werden. Durch Verwendung unterschiedlicher Stutzen kann die Halterung zudem an unterschiedliche Bauteile angepasst werden. Da nur der Rand der Halterung als echte Auflagefläche für das Bauteil dient, können insbesondere Bauteile gehalten werden, deren Außenflächen sich außer im Bereich des gehaltenen Randes unterscheiden. Die Anpassung an die Form der Außenflächen kann dann durch geeignete Wahl der Stutzen erfolgen. Dadurch ist ein hohes Maß an Flexibilität der Halterung möglich.

Wenn der Stutzen bei aufgesetztem Bauteil an die Öffnung in der Außenfläche des Bauteils angrenzt und die Form und der Öffnungsquerschnitt der Austrittsöffnung der Form und dem Öffnungsquerschnitt der Öffnung des internen Kanals des Bauteils entsprechen, kann so mit Hilfe der Stutzen eine störungs- und verlustarme Strömung am Übergang zwischen Halterung und Bauteil erreicht werden. Insbesondere kann der Rand der Austrittsöffnung auch von einer in Richtung der Längsachse des Stutzens vorstehenden Dichtung umgeben sein, um die Leckrate weiter zu verringern.

Der Stutzen kann jedoch auch so ausgestaltet sein, dass er bei aufgesetztem Bauteil in die Öffnung in der Außenfläche des Turbinenbauteils hineinragt. Dadurch kann eine besonders gezielte Zuführung der Gasphase zu dem zu beschichtenden internen Kanal des Bauteils erreicht werden. Insbesondere, wenn die Form und die Abmessung des Außenumfangs des Stutzens der Form der Abmessung der Öffnung in der Außenfläche des Bauteils entspricht, lässt sich die Leckrate und der benötigte Gasphasenstrom gering halten.

Alternativ ist es jedoch auch möglich, die Außenabmessung des Stutzens kleiner zu gestalten als den Öffnungsquerschnitt der Öffnung in der Außenfläche des Bauteils. Dies ermöglicht es einem Teil der Gasphasenströmung entlang des Stutzens bis zum Rand der Öffnung in der Außenfläche des Bauteils zurückströmen. Auf diese Weise lässt sich auch eine zufrieden stellende Alitierung desjenigen Bereiches des internen Kanals des Bauteils erzielen, in dem sich der Stutzen befindet. Der Abstand zwischen der Außenwand des Stutzens und der Innenwand des internen Kanals des Bauteils sollte dabei so gering wie möglich ausfallen, jedoch so groß sein, dass die Rückströmung nicht behindert wird.

Wenn der Stutzen in den internen Kanal hinein ragen soll, so kann er zum weiteren Verringern der Leckrate eine seine äußere Umfangfläche umgebende Dichtung aufweisen, die sich an die Lagerfläche anschließt und sich über einen Teil der axialen Länge des Stutzens erstreckt.

In einer Weiterbildung der Ausgestaltung mit Stutzen kann der Strömungskanal im Lagerelement eine Kammer und mehrere in der Lagerfläche angeordnete verschließbare Kammeröffnungen aufweisen. Die Stutzen sind mit Durchgangskanälen ausgestattet und derart im Bereich der Kammeröffnung am Lagerelement fixierbar, dass der Durchgangskanal eines fixierten Stutzens mit der entsprechenden Kammeröffnung fluchtet. Der Durchgangskanal stellt dann einen Teil des Strömungskanals der Halterung dar. Durch geeignete Anordnung der verschließbaren Öffnungen und geeignete Sätze von unterschiedlichen Stutzen kann die Halterung dieser Ausgestaltung optimal an die Form der Außenfläche des gehaltenen Bauteils angepasst werden. Nicht benutze Kammeröffnungen lassen sich dabei verschließen, um einen unkontrollierten Austritt der Gasphase zu vermeiden.

Die erfindungsgemäße Halterung kann insbesondere zum Halten eines Turbinenbauteils, beispielsweise einer Lauf- oder Leitschaufel einer Turbine oder zum Halten eines Hitzeschildelementes für eine Brennkammer, ausgestaltet sein.

Weitere Merkmale, Eigenschaften und Vorteile der vorliegenden Erfindung ergeben sich aus der nachfolgenden Beschreibung von Ausführungsbeispielen unter Bezugnahme auf die beiliegenden Figuren.
- Fig. 1: zeigt beispielhaft eine Gasturbine in einem Längsteilschnitt.
- Fig. 2: zeigt die perspektivische Ansicht einer Laufschaufel oder einer Leitschaufel einer Strömungsmaschine.
- Fig. 3: zeigt eine Brennkammer einer Gasturbine.
- Fig. 4: zeigt ein erstes Ausführungsbeispiel für die erfindungsgemäße Halterung.
- Fig. 5: zeigt ein zweites Ausführungsbeispiel für die erfindungsgemäße Halterung.
- Fig. 6: zeigt ein drittes Ausführungsbeispiel für die erfindungsgemäße Halterung.
- Fig. 7: zeigt ein viertes Ausführungsbeispiel für die erfindungsgemäße Halterung.
- Fig. 8: zeigt ein Detail aus Fig. 7.
- Fig. 9: zeigt ein Detail aus Fig. 4.

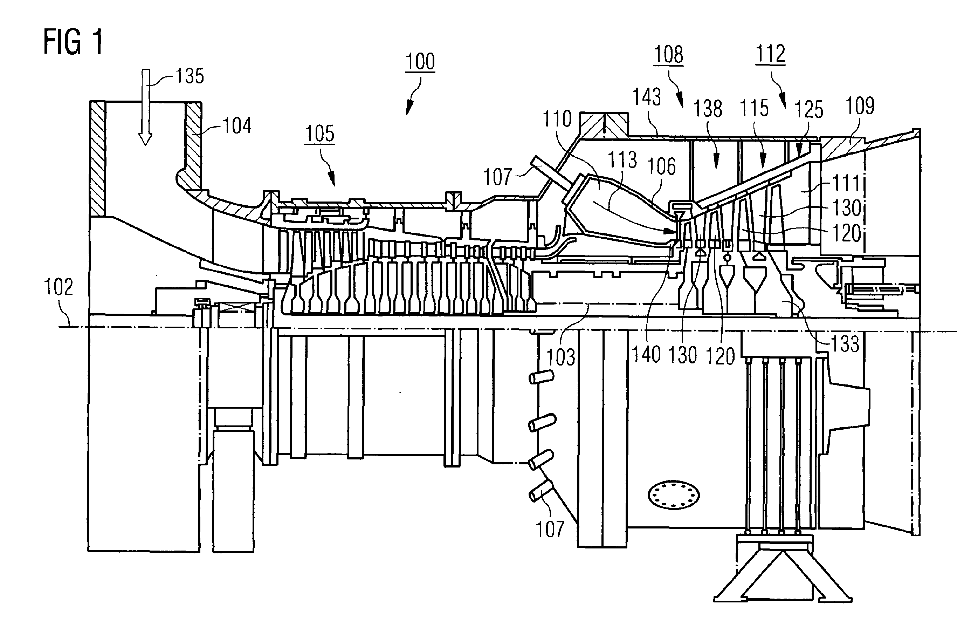

Die Figur 1 zeigt beispielhaft eine Gasturbine 100 in einem Längsteilschnitt. Die Gasturbine 100 weist im Inneren einen um eine Rotationsachse 102 drehgelagerten Rotor 103 auf, der auch als Turbinenläufer bezeichnet wird. Entlang des Rotors 103 folgen aufeinander ein Ansauggehäuse 104, ein Verdichter 105, eine beispielsweise torusartige Brennkammer 110, insbesondere Ringbrennkammer 106, mit mehreren koaxial angeordneten Brennern 107, eine Turbine 108 und das Abgasgehäuse 109.

Die Ringbrennkammer 106 kommuniziert mit einem beispielsweise ringförmigen Heißgaskanal 111. Dort bilden beispielsweise vier hintereinandergeschaltete Turbinenstufen 112 die Turbine 108.

Jede Turbinenstufe 112 ist beispielsweise aus zwei Schaufelringen gebildet. In Strömungsrichtung eines Arbeitsmediums 113 gesehen folgt im Heißgaskanal 111 einer Leitschaufelreihe 115 eine aus Laufschaufeln 120 gebildete Reihe 125.

Die Leitschaufeln 130 sind dabei an einem Innengehäuse 138 eines Stators 143 befestigt, wohingegen die Laufschaufeln 120 einer Reihe 125 beispielsweise mittels einer Turbinenscheibe 133 am Rotor 103 angebracht sind.

An dem Rotor 103 angekoppelt ist ein Generator oder eine Arbeitsmaschine (nicht dargestellt).

Während des Betriebes der Gasturbine 100 wird vom Verdichter 105 durch das Ansauggehäuse 104 Luft 135 angesaugt und verdichtet. Die am turbinenseitigen Ende des Verdichters 105 bereitgestellte verdichtete Luft wird zu den Brennern 107 geführt und dort mit einem Brennmittel vermischt. Das Gemisch wird dann unter Bildung des Arbeitsmediums 113 in der Brennkammer 110 verbrannt. Von dort aus strömt das Arbeitsmedium 113 entlang des Heißgaskanals 111 vorbei an den Leitschaufeln 130 und den Laufschaufeln 120. An den Laufschaufeln 120 entspannt sich das Arbeitsmedium 113 impulsübertragend, so dass die Laufschaufeln 120 den Rotor 103 antreiben und dieser die an ihn angekoppelte Arbeitsmaschine.

Die dem heißen Arbeitsmedium 113 ausgesetzten Bauteile unterliegen während des Betriebes der Gasturbine 100 thermischen Belastungen. Die Leitschaufeln 130 und Laufschaufeln 120 der in Strömungsrichtung des Arbeitsmediums 113 gesehen ersten Turbinenstufe 112 werden neben den die Ringbrennkammer 106 auskleidenden Hitzeschildsteinen am meisten thermisch belastet.

Um den dort herrschenden Temperaturen standzuhalten, können diese mittels eines Kühlmittels gekühlt werden.

Ebenso können Substrate der Bauteile eine gerichtete Struktur aufweisen, d.h. sie sind einkristallin (SX-Struktur) oder weisen nur längsgerichtete Körner auf (DS-Struktur).

Als Material für die Bauteile, insbesondere für die Turbinenschaufel 120, 130 und Bauteile der Brennkammer 110 werden beispielsweise eisen-, nickel- oder kobaltbasierte Superlegierungen verwendet. Solche Superlegierungen sind beispielsweise aus der EP 1204776 B1, EP 1306454, EP 1319729 A1, WO 99/67435 oder WO 00/44949 bekannt; diese Schriften sind Teil der Offenbarung.

Ebenso können die Schaufeln 120, 130 Beschichtungen gegen Korrosion (MCrAlX; M ist zumindest ein Element der Gruppe Eisen (Fe), Kobalt (Co), Nickel (Ni), X ist ein Aktivelement und steht für Yttrium (Y) und/oder Silizium und/oder zumindest ein Element der Seltenen Erden bzw. Hafnium). Solche Legierungen sind bekannt aus der EP 0 486 489 B1, EP 0 786 017 B1, EP 0 412 397 B1 oder EP 1 306 454 A1, die Teil dieser Offenbarung sein sollen.

Auf der MCrAlX kann noch eine Wärmedämmschicht vorhanden sein, und besteht beispielsweise aus ZrO₂, Y₂O₃-ZrO₂, d.h. sie ist nicht, teilweise oder vollständig stabilisiert durch Yttriumoxid und/oder Kalziumoxid und/oder Magnesiumoxid.

Durch geeignete Beschichtungsverfahren wie z.B. Elektronenstrahlverdampfen (EB-PVD) werden stängelförmige Körner in der Wärmedämmschicht erzeugt.

Die Leitschaufel 130 weist einen dem Innengehäuse 138 der Turbine 108 zugewandten Leitschaufelfuß (hier nicht dargestellt) und einen dem Leitschaufelfuß gegenüberliegenden Leitschaufelkopf auf. Der Leitschaufelkopf ist dem Rotor 103 zugewandt und an einem Befestigungsring 140 des Stators 143 festgelegt.

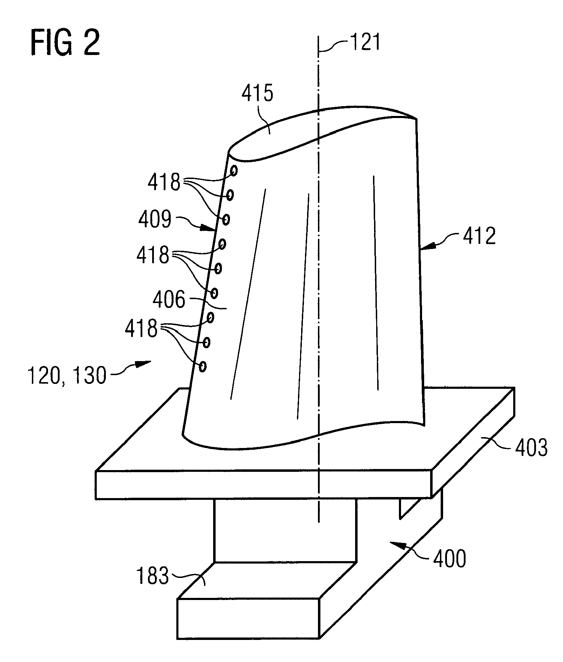

Figur 2 zeigt in perspektivischer Ansicht eine Laufschaufel 120 oder Leitschaufel 130 einer Strömungsmaschine, die sich entlang einer Längsachse 121 erstreckt.

Die Strömungsmaschine kann eine Gasturbine eines Flugzeugs oder eines Kraftwerks zur Elektrizitätserzeugung, eine Dampfturbine oder ein Kompressor sein.

Die Schaufel 120, 130 weist entlang der Längsachse 121 aufeinander folgend einen Befestigungsbereich 400, eine daran angrenzende Schaufelplattform 403. sowie ein Schaufelblatt 406 auf. Als Leitschaufel 130 kann die Schaufel 130 an ihrer Schaufelspitze 415 eine weitere Plattform aufweisen (nicht dargestellt).

Im Befestigungsbereich 400 ist ein Schaufelfuß 183 gebildet, der zur Befestigung der Laufschaufeln 120, 130 an einer Welle oder einer Scheibe dient (nicht dargestellt).
Der Schaufelfuß 183 ist beispielsweise als Hammerkopf ausgestaltet. Andere Ausgestaltungen als Tannenbaum- oder Schwalbenschwanzfuß sind möglich.

Die Schaufel 120, 130 weist für ein Medium, das an dem Schaufelblatt 406 vorbeiströmt, eine Anströmkante 409 und eine Abströmkante 412 auf.

Bei herkömmlichen Schaufeln 120, 130 werden in allen Bereichen 400, 403, 406 der Schaufel 120, 130 beispielsweise massive metallische Werkstoffe, insbesondere Superlegierungen verwendet. Solche Superlegierungen sind beispielsweise aus der EP 1204776 B1, EP 1306454, EP 1319729 A1, WO 99/67435 oder WO 00/44949 bekannt; diese Schriften sind Teil der Offenbarung. Die Schaufel 120, 130 kann hierbei durch ein Gussverfahren, auch mittels gerichteter Erstarrung, durch ein Schmiedeverfahren, durch ein Fräsverfahren oder Kombinationen daraus gefertigt sein.

Werkstücke mit einkristalliner Struktur oder Strukturen werden als Bauteile für Maschinen eingesetzt, die im Betrieb hohen mechanischen, thermischen und/oder chemischen Belastungen ausgesetzt sind. Die Fertigung von derartigen einkristallinen Werkstücken erfolgt z.B. durch gerichtetes Erstarren aus der Schmelze. Es handelt sich dabei um Gießverfahren, bei denen die flüssige metallische Legierung zur einkristallinen Struktur, d.h. zum einkristallinen Werkstück, oder gerichtet erstarrt. Dabei werden dendritische Kristalle entlang dem Wärmefluss ausgerichtet und bilden entweder eine stängelkristalline Kornstruktur (kolumnar, d.h. Körner, die über die ganze Länge des Werkstückes verlaufen und hier, dem allgemeinen Sprachgebrauch nach, als gerichtet erstarrt bezeichnet werden) oder eine einkristalline Struktur, d.h. das ganze Werkstück besteht aus einem einzigen Kristall. In diesen Verfahren muss man den Übergang zur globulitischen (polykristallinen) Erstarrung meiden, da sich durch ungerichtetes Wachstum notwendigerweise transversale und longitudinale Korngrenzen ausbilden, welche die guten Eigenschaften des gerichtet erstarrten oder einkristallinen Bauteiles zunichte machen. Ist allgemein von gerichtet erstarrten Gefügen die Rede, so sind damit sowohl Einkristalle gemeint, die keine Korngrenzen oder höchstens Kleinwinkelkorngrenzen aufweisen, als auch Stängelkristallstrukturen, die wohl in longitudinaler Richtung verlaufende Korngrenzen, aber keine transversalen Korngrenzen aufweisen. Bei diesen zweitgenannten kristallinen Strukturen spricht man auch von gerichtet erstarrten Gefügen (directionally solidified structures). Solche Verfahren sind aus der US-PS 6,024,792 und der EP 0 892 090 A1 bekannt; diese Schriften sind Teil der Offenbarung.

Ebenso können die Schaufeln 120, 130 Beschichtungen gegen Korrosion oder Oxidation (MCrAlX; M ist zumindest ein Element der Gruppe Eisen (Fe), Kobalt (Co), Nickel (Ni), X ist ein Aktivelement und steht für Yttrium (Y) und/oder Silizium und/oder zumindest ein Element der Seltenen Erden, bzw. Hafnium (Hf)). Solche Legierungen sind bekannt aus der EP 0 486 489 B1, EP 0 786 017 B1, EP 0 412 397 B1 oder EP 1 306 454 A1, die Teil dieser Offenbarung sein sollen.

Auf der MCrAlX kann noch eine Wärmedämmschicht vorhanden sein und besteht beispielsweise aus ZrO₂, Y₂O₃-ZrO₂, d.h. sie ist nicht, teilweise oder vollständig stabilisiert durch Yttriumoxid und/oder Kalziumoxid und/oder Magnesiumoxid. Durch geeignete Beschichtungsverfahren wie z.B. Elektronenstrahlverdampfen (EB-PVD) werden stängelförmige Körner in der Wärmedämmschicht erzeugt.

Wiederaufarbeitung (Refurbishment) bedeutet, dass Bauteile 120, 130 nach ihrem Einsatz gegebenenfalls von Schutzschichten befreit werden müssen (z.B. durch Sandstrahlen). Danach erfolgt eine Entfernung der Korrosions- und/oder Oxidationsschichten bzw. -produkte. Gegebenenfalls werden auch noch Risse im Bauteil 120, 130 repariert. Danach erfolgt eine Wiederbeschichtung des Bauteils 120, 130 und ein erneuter Einsatz des Bauteils 120, 130.

Die Schaufel 120, 130 kann hohl oder massiv ausgeführt sein. Wenn die Schaufel 120, 130 gekühlt werden soll, ist sie hohl und weist ggf. noch Filmkühllöcher 418 (gestrichelt angedeutet) auf.

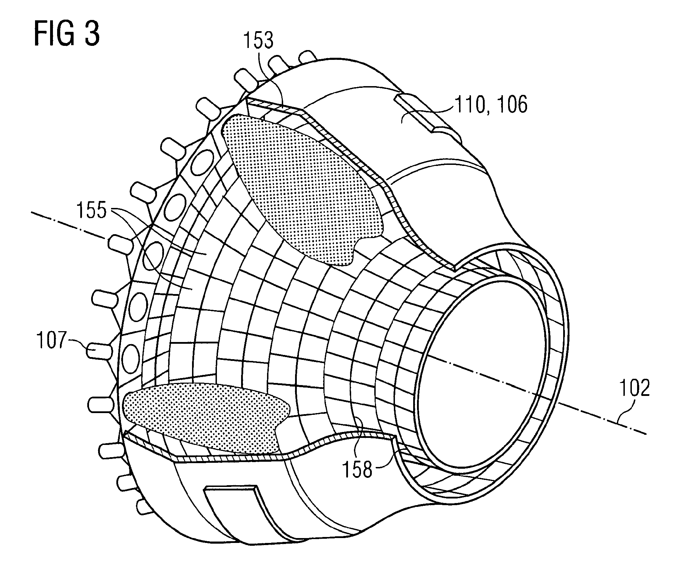

Die Figur 3 zeigt eine Brennkammer 110 einer Gasturbine. Die Brennkammer 110 ist beispielsweise als so genannte Ringbrennkammer ausgestaltet, bei der eine Vielzahl von in Umfangsrichtung um die Rotationsachse 102 herum angeordneten Brennern 107 in einen gemeinsamen Brennkammerraum münden. Dazu ist die Brennkammer 110 in ihrer Gesamtheit als ringförmige Struktur ausgestaltet, die um die Rotationsachse 102 herum positioniert ist.

Zur Erzielung eines vergleichsweise hohen Wirkungsgrades ist die Brennkammer 110 für eine vergleichsweise hohe Temperatur des Arbeitsmediums M von etwa 1000°C bis 1600°C ausgelegt. Um auch bei diesen, für die Materialien ungünstigen Betriebsparametern eine vergleichsweise lange Betriebsdauer zu ermöglichen, ist die Brennkammerwand 153 auf ihrer dem Arbeitsmedium M zugewandten Seite mit einer aus Hitzeschildelementen 155 gebildeten Innenauskleidung versehen.

Jedes Hitzeschildelement 155 ist arbeitsmediumsseitig mit einer besonders hitzebeständigen Schutzschicht ausgestattet oder aus hochtemperaturbeständigem Material gefertigt. Dies können massive keramische Steine oder Legierungen mit MCrAlX und/oder keramischen Beschichtungen sein. Die Materialien der Brennkammerwand und deren Beschichtungen können ähnlich der Turbinenschaufeln sein.

Aufgrund der hohen Temperaturen im Inneren der Brennkammer 110 kann zudem für die Hitzeschildelemente 155 bzw. für deren Halteelemente ein Kühlsystem vorgesehen sein.

Die Brennkammer 110 ist insbesondere für eine Detektion von Verlusten der Hitzeschildelemente 155 ausgelegt. Dazu sind zwischen der Brennkammerwand 153 und den Hitzeschildelementen 155 eine Anzahl von Temperatursensoren 158 positioniert.

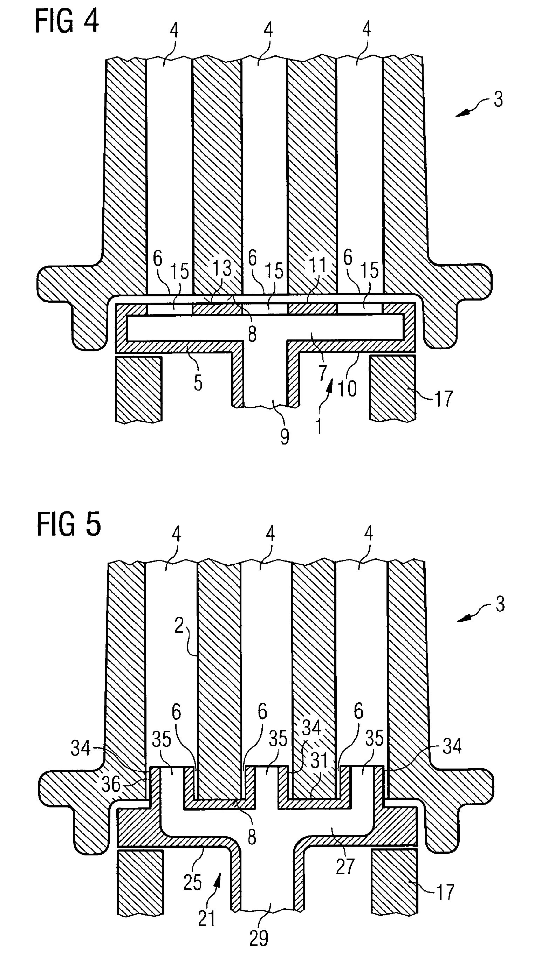

Ein erstes Ausführungsbeispiel für die erfindungsgemäße Halterung ist in Fig. 4 dargestellt. Die Halterung dieses Ausführungsbeispiels sowie die Halterungen der anderen Ausführungsbeispiele stellen Halterungen zum Halten von Turbinenschaufeln während eines Innenalitierungsprozesses dar. Bei dem Innenalitierungsprozess werden Kühlluftkanäle, die im Inneren der Schaufeln verlaufen mittels einer Gasphasenabscheidung über Subhalogenverbindungen mit einer Aluminiumschicht versehen. Eine mögliche Gasphasenabscheidung über Subhalogenverbindungen ist beispielsweise in DE 28 05 370 A1 beschrieben. Auf diese Druckschrift wird daher mit Bezug auf das Abscheideverfahren verwiesen.

Das Zuführen der Subhalogenverbindung erfolgt durch eine Halterung 1, auf die die Turbinenschaufel 3 während des Prozesses aufgesetzt ist. Die Halterung 1 umfasst einen Grundkörper 5 mit einem Hohlraum 7, welcher mit einem Zufuhrkanal 9 zum Zuführen der Subhalogenverbindung in Verbindung steht. In der Oberseite 11 des Grundkörpers 5 sind Austrittsöffnungen 15 angeordnet, durch welche die Subhalogenverbindung aus dem Hohlraum 7 austreten kann.

Der Grundkörper 5 bildet ein Lagerelement für eine zu haltende Turbinenschaufel 3 dessen Oberseite 11 eine Auflagefläche 13 für eine Außenseite der Turbinenschaufel 3, nämlich deren Unterseite 8, bildet. Im vorliegenden Ausführungsbeispiel bilden der Zufuhrkanal 9 und der Hohlraum 7 einen Strömungskanal, durch den beim Durchführen des Innenalitierungsprozesses die Subhalogenverbindung internen Kühlkanälen 4 der Turbinenschaufel 3 zugeführt wird. Die Halterung 1 ist derart an die zu haltende Turbinenschaufel 3 angepasst, dass sich die Austrittsöffnungen 15 genau dort in der Oberseite 11 des Grundkörpers 5 befinden, wo sich bei aufgesetzter Turbinenschaufel 3 die Öffnungen 6 der internen Kühlkanäle 4 in der Außenfläche 8 der Turbinenschaufel 3 befinden. Die Austrittsöffnungen 15 der Halterung 1 liegen dann den Öffnungen 6 der internen Kühlkanäle genau gegenüber. Die Form und der Öffnungsquerschnitt der Austrittsöffnungen 15 sind die gleichen wie die Form und der Öffnungsquerschnitt der Öffnung 6 der internen Kanäle 4. Auf diese Weise kann die Subhalogenverbindung ohne große Störungen der Strömung aus dem Hohlraum 7 im Grundkörper 5 in die internen Kühlkanäle 4 der Turbinenschaufel 3 strömen.

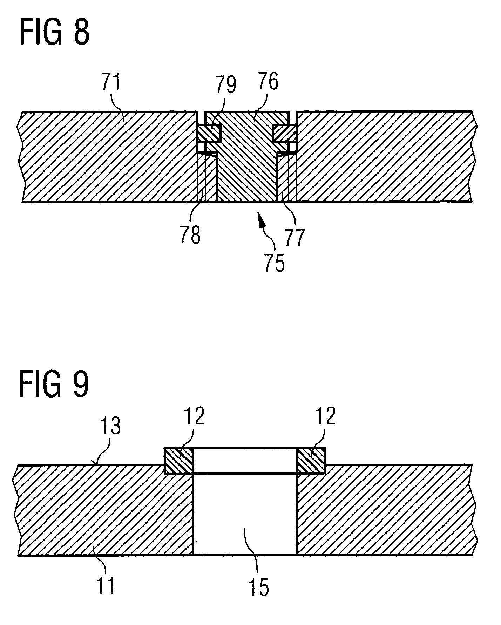

Dadurch, dass die Oberseite 11 der Halterung 1 an die Unterseite 8 der Turbinenschaufel 3 angepasst ist, kann eine relativ leckdichte Auflage der Turbinenschaufel 3 auf der Halterung 1 erreicht werden. So lässt sich eine relativ geringe Leckrate beim Durchtritt der Subhalogenverbindung vom Hohlraum 7 in die internen Kühlkanäle 4 erreichen. Um die Leckrate weiter zu verringern, kann der Rand der Austrittsöffnung 15 von einer verformbaren, vorzugsweise elastisch verformbaren, Dichtung 12 umgeben sein, die ein wenig in die Oberseite 11 des Grundkörpers eingelassen ist und über dessen Oberfläche vorsteht. Bei einer auf die Halterung 1 aufgesetzten Turbinenschaufel 3 wird die Dichtung 12 zusammengedrückt, so dass die Unterseite 8 der Turbinenschaufel 3 auf der Oberseite 11 der Halterung 1 aufliegt. Die Anordnung der Dichtung ist in Fig. 9 im Detail dargestellt.

Während des Alitierungsprozesses wird die Halterung 1 von einem Unterstützungsring 17 im Bereich ihrer Außenkanten unterstützt.

Die in Fig. 4 dargestellte Halterung 1 ist genau an die Form der Turbinenschaufel 3 und an die Lage der Öffnungen 6 ihrer internen Kühlkanäle 4 angepasst. Wenn ein alternatives Schaufeldesign mit einer anderen Lage der Öffnungen einem Alitierungsprozess unterzogen werden soll, so wird die Halterung des ersten Ausführungsbeispiels gegen eine an das alternative Design angepasste Halterung ausgetauscht. Vorzugsweise sind die unterschiedlichen Halterungen im Bereich der Unterseite 10 so ausgebildet, dass sie sich alle mit demselben Unterstützungsring 17 verwenden lassen. Dadurch kann die Zahl der bei einem Wechsel des Schaufeldesigns auszutauschenden Elemente in Grenzen gehalten werden.

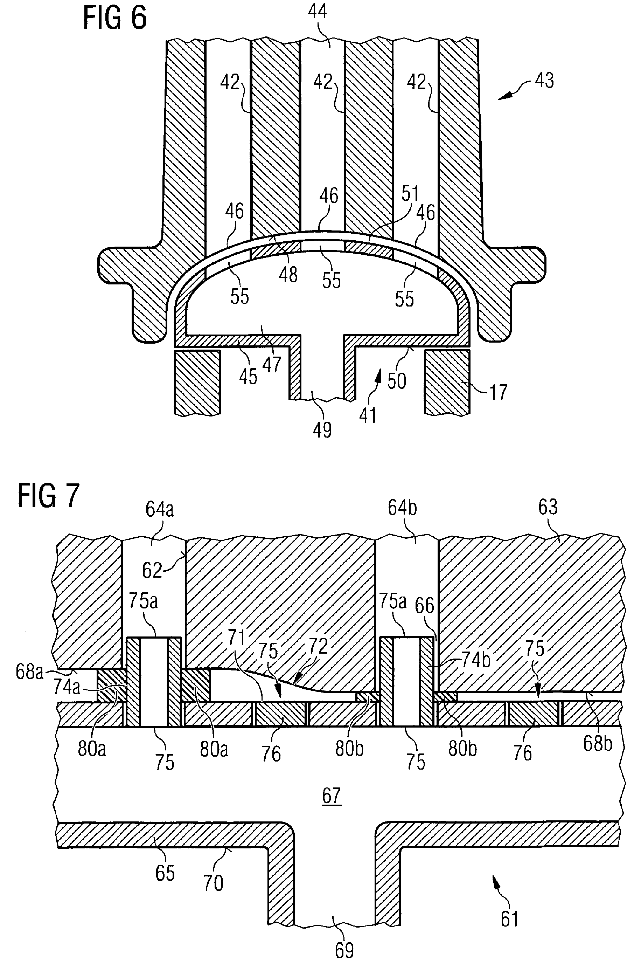

Eine alternative Ausgestaltung der erfindungsgemäßen Halterung ist in Fig. 5 dargestellt. Die Halterung entspricht in ihrer Grundkonzeption der Halterung aus Fig. 4. Im Unterschied zur Halterung 1 des ersten Ausführungsbeispiels sind die Austrittsöffnungen 35 des Hohlraums 27 jedoch nicht direkt in der Oberseite 31 des Grundkörpers 25 angeordnet, sondern am von der Oberseite 31 entfernten Ende von über die Oberseite 31 vorstehenden Stutzen 34. Die Stutzen 34 stehen soweit über die Oberseite 31 des Grundkörpers 25 vor, dass sie ein Stück weit in die internen Kühlkanäle 4 der Turbinenschaufel 3 hineinragen. Die Form und die Außenabmessungen der Stutzen 34 sind dabei so gewählt, dass ein geringer Abstand zwischen der Außenseite 36 und der Innenseite 2 der Kühlkanäle 4 verbleibt. Auf diese Weise kann die Subhalogenverbindung in den Zwischenraum zwischen der Außenseite des Stutzens 34 und der Innenseite der Kühlkanäle 4 strömen und auch dort eine Alitierung herbeiführen.

Ein drittes Ausführungsbeispiel für die erfindungsgemäße Halterung ist in Fig. 6 dargestellt. Die dargestellte Halterung 41 entspricht im Wesentlichen der in Fig. 1 dargestellten Halterung mit dem Unterschied, dass sie an ein anderes Schaufeldesign angepasst ist. Die in Fig. 6 dargestellte Turbinenschaufel 43 weist im Unterschied zur in Fig. 1 dargestellten Turbinenschaufel 3 eine gebogene Unterseite 48 auf, in der die Öffnungen 46 der internen Kühlkanäle 44 angeordnet sind. Die Oberseite 51 des Grundkörpers 45 der Halterung 50 ist im dritten Ausführungsbeispiel an die gebogene Form der Unterseite 48 der Turbinenschaufel 43 angepasst, d.h. sie weist eine entsprechende Wölbung auf. Im Übrigen unterscheidet sich dieses Ausführungsbeispiel nicht vom in Fig. 1 dargestellten Ausführungsbeispiel.

Ein viertes Ausführungsbeispiel der erfindungsgemäßen Halterung ist ausschnittsweise in Fig. 7 gezeigt. Das in Fig. 7 dargestellte Ausführungsbeispiel einer erfindungsgemäßen Halterung 61 weist zwar eine größere Komplexität als die in den Fig. 4 bis 6 dargestellten Ausführungsbeispiele auf, besitzt dafür jedoch auch eine höhere Flexibilität, da sie für verschiedene Schaufeldesigns zur Anwendung kommen kann. Während die Unterseite 65, der Hohlraum 67 und der Zufuhrkanal 69 mit den entsprechenden Elementen im ersten Ausführungsbeispiel übereinstimmen, weist die Oberseite 71 der Halterung 61 des vierten Ausführungsbeispiels mehr Austrittsöffnungen 75 auf, als die Turbinenschaufel 63 Öffnungen 66 von internen Kühlkanälen 64 besitzt. Die für die Turbinenschaufel 63 nicht genutzten Austrittsöffnungen 75 sind während des Alitierprozesses für diese Turbinenschaufel 63 mit einem Stopfen 76 verschlossen. In die übrigen Öffnungen 75 sind abnehmbare Stutzen 74a und 74b eingesetzt und ebenso wie die Stopfen 76 gasdicht in der Oberseite 71 des Grundkörpers 65 fixiert. Das Fixieren ist in Fig. 8 am Beispiel eines Stopfens 76 dargestellt. Dasselbe Fixierprinzip kommt jedoch auch bei den Stutzen 74a und 74b zur Anwendung. Der Stopfen 76 ist mit einem Außengewinde 77 versehen, das mit einem Innengewinde 78 der Oberseite 71 im Bereich der Austrittsöffnung 75 zusammenwirkt. Das Außengewinde 77 und das Innengewinde 78 erstrecken sich jedoch nicht über die gesamte Tiefe des Stopfens 76 bzw. der Oberseite 71 sondern nur über einen Teil der Tiefe, im vorliegenden Ausführungsbeispiel etwa über die Hälfte. Im der Turbinenschaufel 63 zugewandten Teil des Stopfens 76 bzw. der Austrittsöffnung 75 ist dagegen kein Gewinde angeordnet. Stattdessen weist der Umfang des Stopfens 76 in diesem Bereich eine Reibdichtung 79 auf, die für einen gasdichten Abschluss der Austrittsöffnung 75 bei eingesetztem Stopfen 76 sorgt. Die beschriebene Fixierung stellt lediglich ein Beispiel für eine mögliche Fixierung dar. Alternative Fixiermethoden können jedoch auch zum Einsatz kommen.

Die Stutzen 74a bzw. 74b weisen im in Fig. 7 dargestellten Ausführungsbeispiel unterschiedliche Längen auf. Der Grund hierfür ist, dass die Unterseite 68 der Turbinenschaufel 63 eine Stufe 72 aufweist, welche die Unterseite in einen ersten Abschnitt 68a und einen zweiten Abschnitt 86b unterteilt. Die Oberseite 71 des Grundkörpers 65 der Halterung 61 ist jedoch nicht an die Form der Unterseite 68 der Turbinenschaufel 63 angepasst. Dies führt im vorliegenden Ausführungsbeispiel dazu, dass die Turbinenschaufel 63 im Bereich 68b mit ihrer Unterseite auf der Oberseite 71 des Grundkörpers 65 aufliegt, während zwischen dem Bereich 68a und der Oberseite 71 ein Spalt verbleibt. Damit die beiden Stutzen 74a, 74b gleich weit in die internen Kühlkanäle 64 hineinragen, weist der Stutzen 74a im Vergleich zum Stutzen 74b eine größere Länge auf. Mit Hilfe des Stutzens 74a kann daher die Austrittsöffnung 75 des Hohlraums 67 in den internen Kühlkanal 64a der Turbinenschaufel 67 hineinverlagert werden. Im Kühlkanal 64b der Turbinenschaufel 63 kann diese Hineinverlagerung der Öffnung 75 dagegen mit einem kürzeren Stutzen 74b erreicht werden. Im an die Oberseite 71 des Grundkörpers 65 angrenzenden Bereich sind die Stutzen zu Dichtzwecken mit einer verformbaren Dichtung 80a, 80b umgeben. Diese erstreckt sich um den gesamten Umfang des jeweiligen Stutzens 74a, 74b, jedoch nur über einen Teil seiner axialen Länge. Dabei sind die Abmessungen der verformbaren Dichtungen 80a, 80b an die Maße des Spaltes zwischen der Turbinenschaufel 63 und der Haltung 61 angepasst, dass sich eine optimale Dichtwirkung erzielen lässt. Die verformbare Dichtung ist vorzugsweise elastisch ausgebildet.

Falls anstatt der in Fig. 7 dargestellten Turbinenschaufel 63 eine Turbinenschaufel 3 Verwendung findet, wie sie in den Fig. 4 und 5 dargestellt ist, so kann der Stutzen 64a durch einen Stutzen 74b mit einer kürzeren Länge ersetzt werden. Alternativ ist es auch möglich, die Stutzen völlig weg zu lassen und die Halterung entsprechend der Halterung 1 des ersten Ausführungsbeispiels zu verwenden. Zudem ist es auch möglich, die in Fig. 7 dargestellte Ausführungsvariante mit verschließbaren Austrittsöffnungen und einsetzbaren Stutzen auch bei Halterungen mit Oberseiten zu verwenden, die an die Außenfläche der Turbinenschaufel, in der die Austrittsöffnungen angeordnet sind, angepasst ist. In diesem Fall werden in der Regel bei Verwendung von Stutzen alle Stutzen die gleiche Länge aufweisen.

In den dargestellten Ausführungsbeispielen war jeweils ein Zufuhrkanal zum Zuführen der Subhalogenverbindung vorhanden. Es können jedoch auch mehrere Zufuhrkanäle zum Zuführen de Subhalogenverbindung in den Hohlraum vorhanden sein. Auch braucht der Zufuhrkanal nicht im Zentrum der Unterseite angeordnet zu sein, auch wenn dies im Hinblick auf eine optimale Verteilung der Strömung im Hohlraum vorteilhaft sein kann.

## Patentansprüche

1. Halterung (1, 21, 41, 61) zum Halten eines metallischen Bauteils (3, 43, 63),
welches wenigstens einen über eine Öffnung (6, 46, 66) in einer Außenfläche (8, 48, 68) des Bauteils (3, 43, 63) zugänglichen internen Kanal (4, 44, 64) aufweist, mit
- einem Lagerelement (5, 25, 45, 65), welches eine Lagerfläche (11, 31, 51, 71) umfasst, die derart ausgestaltet ist, dass sie ein Aufsetzen des Bauteils (3, 43, 63) auf das Lagerelement (5, 25, 45, 65) zulässt und dabei wenigstens einem Teil der die Öffnung (6, 46, 66) aufweisenden Außenfläche (8, 48, 68) des Bauteils (1, 21, 41, 61) als Auflage dient, und
- einem durch das Lagerelement (5, 25, 45, 65) hindurchführenden Strömungskanal (7, 27, 47, 67) mit wenigstens einer in der Lagerfläche (11, 31, 51, 71) angeordneten Austrittsöffnung (15, 35, 55, 75), wobei
die Austrittsöffnung (15, 35, 55, 75) derart in der Lagerfläche (11, 31, 51, 71) angeordnet ist, dass sie bei aufgesetztem Bauteil (3, 43, 63) der Öffnung des internen Kanals (4, 44, 64) gegenüber liegt und die Austrittsöffnung (15, 35, 55, 75) in Form und Strömungsquerschnitt an die Öffnung (6, 46, 66) des internen Kanals (4, 44, 64) angepasst ist.

2. Halterung (1) nach Anspruch 1,
in der der Rand der Austrittsöffnung (15) von einer über Lagerfläche (11) vorstehenden Dichtung (12) umgeben ist.

3. Halterung (61) nach Anspruch 1 oder 2,
in der der Strömungskanal (67) mehrere an unterschiedlichen Orten der Lagerfläche (71) angeordnete verschließbare Austrittsöffnungen (75) aufweist.

4. Halterung (1, 21, 41) nach einem der Ansprüche 1 bis 3,
in der die Form der Lagerfläche (11, 31, 51) der Form der Außenfläche (8, 48) des zu haltenden Bauteils (3, 43) entspricht.

5. Halterung (21, 61) nach Anspruch 1
mit wenigstens einem über die Lagerfläche (31, 71) des Lagerelementes (25, 65) vorstehenden Stutzen (34, 74), durch den der Strömungskanal führt und an dessen von der Lagerfläche (31, 71) entfernten Ende die Austrittsöffnung (35, 75a) angeordnet ist,
wobei der Stutzen (34, 74) derart in der Lagerfläche (31, 71) angeordnet ist, dass er bei aufgesetztem Bauteil (3, 63) an die Öffnung (6, 66) in der Außenfläche (8, 68) des Bauteils (3, 63) angrenzt oder in diese hineinragt.

6. Halterung (21, 61) nach Anspruch 5,
in der der Stutzen (34, 74) bei aufgesetztem Bauteil (3, 63) an die Öffnung (6, 66) in der Außenfläche (8, 68)des Bauteils (3, 63) angrenzt und Form und Öffnungsquerschnitt der Austrittsöffnung (35, 75a) der Form und dem Öffnungsquerschnitt des internen Kanals (4, 64) entsprechen.

7. Halterung (61) nach Anspruch 6,
in der der Rand der Austrittsöffnung (75, 75a) von einer in Richtung der Längsachse des Stutzens vorstehenden Dichtung (80) umgeben ist.

8. Halterung (21, 61) nach Anspruch 5,
in der der Stutzen (34, 74) bei aufgesetztem Bauteil (3, 63) in die Öffnung (6, 66) in der Außenfläche (8, 68) des Bauteils (3, 63) hineinragt.

9. Halterung (21, 61) nach Anspruch 8,
in der die Form und die Abmessung des Außenumfangs des Stutzens (34, 74) der Form und der Abmessung der Öffnung (6, 66) in der Außenfläche (8, 68) des Bauteils (3, 63) entspricht.

10. Halterung (21, 61) nach Anspruch 8,
in der die Außenabmessung des Stutzens (34, 74) kleiner ist, als der Strömungsquerschnitt des internen Kanals (4, 64) .

11. Halterung (61) nach Anspruch 9 oder 10,
in der die äußere Umfangsfläche des Stutzens (74) in einem Abschnitt, der sich an die Lagerfläche (71) anschließt und sich wenigstens über einen Teil der Länge des Stutzens (74) erstreckt, mit einer Dichtung (12) umgeben ist.

12. Halterung (61) nach einem der Ansprüche 5 bis 11,
in dem der Strömungskanal im Lagerelement (65) eine Kammer (67) und mehrere in der Lagerfläche (71) angeordnete verschließbare Kammeröffnungen (75) aufweist, und in dem Stutzen (74) mit Durchgangsöffnungen ausgestattet sind und derart im Bereich der Kammeröffnungen (75) am Lagerelement (65) fixierbar sind, dass der Durchgangskanal eines fixierten Stutzens (74) mit einer der Kammeröffnung (75) fluchtet.

13. Halterung (1, 21, 41, 61) nach einem der vorangehenden Ansprüche,
**dadurch gekennzeichnet,**
**dass** sie zum Halten eines Turbinenbauteils (3, 43, 63) als Bauteil ausgestaltet ist.

## Geänderte Patentansprüche

### Geänderte Patentansprüche gemäss Regel 86(2) EPÜ.

**1.** Halterung (1, 21, 41, 61) zum Halten eines metallischen Bauteils (3, 43, 63),
welches wenigstens einen über eine Öffnung (6, 46, 66) in einer Außenfläche (8, 48, 68) des Bauteils (3, 43, 63) zugänglichen internen Kanal (4, 44, 64) aufweist, mit
- einem Lagerelement (5, 25, 45, 65), welches eine Lagerfläche (11, 31, 51, 71) umfasst, die derart ausgestaltet ist, dass sie ein Aufsetzen des Bauteils (3, 43, 63) auf das Lagerelement (5, 25, 45, 65) zulässt und dabei wenigstens einem Teil der die Öffnung (6, 46, 66) aufweisenden Außenfläche (8, 48, 68) des Bauteils (1, 21, 41, 61) als Auflage dient, und
- einem durch das Lagerelement (5, 25, 45, 65) hindurchführenden Strömungskanal (7, 27, 47, 67) mit wenigstens einer in der Lagerfläche (11, 31, 51, 71) angeordneten Austrittsöffnung (15, 35, 55, 75), wobei
die Austrittsöffnung (15, 35, 55, 75) derart in der Lagerfläche (11, 31, 51, 71) angeordnet ist, dass sie bei aufgesetztem Bauteil (3, 43, 63) der Öffnung des internen Kanals (4, 44, 64) gegenüber liegt und die Austrittsöffnung (15, 35, 55, 75) in Form und Strömungsquerschnitt an die Öffnung (6, 46, 66) des internen Kanals (4, 44, 64) angepasst ist und
mit wenigstens einem über die Lagerfläche (31, 71) des Lagerelementes (25, 65) vorstehenden Stutzen (34, 74), durch den der Strömungskanal führt und an dessen von der Lagerfläche (31, 71) entfernten Ende die Austrittsöffnung (35, 75a) angeordnet ist,
wobei der Stutzen (34, 74) derart in der Lagerfläche (31, 71) angeordnet ist, dass er bei aufgesetztem Bauteil (3, 63) an die Öffnung (6, 66) in der Außenfläche (8, 68) des Bauteils (3, 63) angrenzt oder in diese hineinragt.

**2.** Halterung (1) nach Anspruch 1,
in der der Rand der Austrittsöffnung (15) von einer über Lagerfläche (11) vorstehenden Dichtung (12) umgeben ist.

**3.** Halterung (61) nach Anspruch 1 oder 2,
in der der Strömungskanal (67) mehrere an unterschiedlichen Orten der Lagerfläche (71) angeordnete verschließbare Austrittsöffnungen (75) aufweist.

**4.** Halterung (1, 21, 41) nach einem der Ansprüche 1 bis 3,
in der die Form der Lagerfläche (11, 31, 51) der Form der Außenfläche (8, 48) des zu haltenden Bauteils (3, 43) entspricht.

**5.** Halterung (21, 61) nach Anspruch 4,
in der der Stutzen (34, 74) bei aufgesetztem Bauteil (3, 63) an die Öffnung (6, 66) in der Außenfläche (8, 68)des Bauteils (3, 63) angrenzt und Form und Öffnungsquerschnitt der Austrittsöffnung (35, 75a) der Form und dem Öffnungsquerschnitt des internen Kanals (4, 64) entsprechen.

**6.** Halterung (61) nach Anspruch 5,
in der der Rand der Austrittsöffnung (75, 75a) von einer in Richtung der Längsachse des Stutzens vorstehenden Dichtung (80) umgeben ist.

**7.** Halterung (21, 61) nach Anspruch 6,
in der der Stutzen (34, 74) bei aufgesetztem Bauteil (3, 63) in die Öffnung (6, 66) in der Außenfläche (8, 68) des Bauteils (3, 63) hineinragt.

**8.** Halterung (21, 61) nach Anspruch 7,
in der die Form und die Abmessung des Außenumfangs des Stutzens (34, 74) der Form und der Abmessung der Öffnung (6, 66) in der Außenfläche (8, 68) des Bauteils (3, 63) entspricht.

**9.** Halterung (21, 61) nach Anspruch 7,
in der die Außenabmessung des Stutzens (34, 74) kleiner ist, als der Strömungsquerschnitt des internen Kanals (4, 64).

**10.** Halterung (61) nach Anspruch 8 oder 9,
in der die äußere Umfangsfläche des Stutzens (74) in einem Abschnitt, der sich an die Lagerfläche (71) anschließt und sich wenigstens über einen Teil der Länge des Stutzens (74) erstreckt, mit einer Dichtung (12) umgeben ist.

**11.** Halterung (61) nach einem der Ansprüche 4 bis 10,
in dem der Strömungskanal im Lagerelement (65) eine Kammer (67) und mehrere in der Lagerfläche (71) angeordnete verschließbare Kammeröffnungen (75) aufweist, und in dem Stutzen (74) mit Durchgangsöffnungen ausgestattet sind und derart im Bereich der Kammeröffnungen (75) am Lagerelement (65) fixierbar sind, dass der Durchgangskanal eines fixierten Stutzens (74) mit einer der Kammeröffnung (75) fluchtet.

**12.** Halterung (1, 21, 41, 61) nach einem der vorangehenden Ansprüche,
**dadurch gekennzeichnet,**
**dass** sie zum Halten eines Turbinenbauteils (3, 43, 63) als Bauteil ausgestaltet ist.
